# EUROPEAN PATENT APPLICATION

(11) **EP 4 654 473 A1**
(43) Date of publication of application: **26.11.2025**
(21) Application number: 25174452.0
(22) Date of filing: 06.05.2025
(51) Int. Cl.: H03G 3/30

(54) **AUTOMATIC GAIN CONTROL IN A WIRELESS LOCAL AREA NETWORK RECEIVER**

(30) Priority: 20.05.2024 US 202418668866
(71) Applicant: Avago Technologies International Sales Pte. Limited, Singapore 768923 (SG)
(72) Inventor: Rajashekar, Rakshith Mysore, 570004 Mysore, KA (IN); Kanchi, Venkateswara Rao, 560068 Bangalore, KA (IN); Singhal, Kamal Agarwal, 560035 Bangalore, KA (IN); Srinivasan, Sudharshan, 560035 Bangalore, KA (IN); Prabhakaran, Dinakar, 560103 Bangalore, KA (IN); Javvadi, Varaprasad, 560102 Bangalore, KA (IN)
(74) Representative: Grünecker Patent- und Rechtsanwälte PartG mbB

(57) **Abstract**

An example receiver includes: a first power estimator operable to receive an in-phase signal; a second power estimator operable to receive a quadrature signal; a combiner coupled to outputs of the first and second power estimators, the combiner having an output that supplies estimated signal power; and an automatic gain controller coupled to the output of the combiner, the automatic gain controller operable to, in a first mode, turn off one of the first or second power estimators such that the one of the first or second power estimators is an inactive power estimator and the other is an active power estimator, and control the combiner to generate the estimated signal power using a function of an output of active power estimator.

## Description

### BACKGROUND

The IEEE 802.11 family of technical standards ("802.11") define protocols for wireless local area networks (WLANs). The 802.11 family includes a series of half-duplex, over- the-air modulation techniques that use the same basic protocol. The 802.11 family employs carrier-sense multiple access with collision avoidance (CSMA/CA) where a WLAN radio listens to a channel for other users before transmitting each frame. Many standards in the 802.11 family use orthogonal frequency division multiplexing (OFDM) to control interference. The OFDM subcarriers can be modulated using binary phase-shift keying (BPSK), quadrature phase-shift keying (QPSK), and quadrature amplitude modulation (QAM). The OFDM symbols are modulated onto in-phase and quadrature-phase ("quadrature") components (e.g.,, the quadrature component being 90 degrees out of phase with respect to the in-phase component) of an RF carrier.

Due to the fundamental nature of carrier sense multiple access (CSMA) and its variants employed in a WLAN, every device on the WLAN network senses the wireless medium before transmitting any frame. Further, a WLAN device continuously monitors the wireless medium to receive frames intended for the device. As a result, the WLAN devices spend a significant amount of time in a listen mode where the devices perform the wireless medium sensing. During the listen mode, a WLAN device performs automatic gain control (AGC) continuously. The purpose of AGC is to maintain the incoming signal at a consistent, optimal level for processing, regardless of variations in the signal's strength as it reaches the WLAN receiver. The received signal strength indicator (RSSI) of WLAN frames at the receiver antenna may vary depending on factors such as propagation loss, environment induced fading, and the like. The AGC adjusts the WLAN receiver gain to compensate for variations in RSSI and to ensure that the frame of interest occupies an optimal number of bits when digitized for further processing.

A WLAN frame includes a preamble meant for AGC, estimation/correction of frequency offset between transmitter and receiver, timing synchronization, channel estimation, and the like. The WLAN receiver senses the wireless medium continuously as discussed above and then performs AGC upon arrival of any WLAN frame having the preamble. The AGC detects the arrival of a WLAN frame using estimates of RSSI. The continuous sensing and RSSI estimation during listen mode involves computation of total received power of the in-phase (I) and quadrature (Q) components of the received signal. Hence, a WLAN receiver includes both an in-phase power estimator and a quadrature power estimator for use by the AGC. Operating both I and Q power estimators in the WLAN receiver during listen mode consumes significant power given that the WLAN receiver spends a significant amount of time in the listen mode.

### SUMMARY

In an embodiment, a receiver includes a first power estimator operable to receive an in-phase signal and a second power estimator operable to receive a quadrature signal. The receiver includes a combiner coupled to outputs of the first and second power estimators, the combiner having an output that supplies estimated signal power. The receiver includes an automatic gain controller coupled to the output of the combiner. The automatic gain controller is operable to, in a first mode, turn off one of the first or second power estimators such that the one of the first or second power estimators is an inactive power estimator and the other is an active power estimator, and control the combiner to generate the estimated signal power using a function of an output of active power estimator.

In an embodiment, a receiver includes a radio frequency (RF) front end, an analog baseband circuit coupled to the RF front end, and a digital baseband circuit coupled to the analog baseband circuit. The receiver includes a power estimator comprising a first power estimator operable to receive an in-phase signal, a second power estimator operable to receive a quadrature signal, and a combiner coupled to outputs of the first and second power estimators, the combiner having an output that supplies estimated signal power. The receiver includes an automatic gain controller coupled to the output of the combiner. The automatic gain controller is operable to, in a first mode, turn off one of the first or second power estimators such that the one of the first or second power estimators is an inactive power estimator and the other is an active power estimator, and control the combiner to generate the estimated signal power using a function of an output of active power estimator. The RF front end and the analog baseband circuit are operable to generate the in-phase signal and the quadrature signal.

In an embodiment, a method of automatic gain control in a receiver includes sensing, by the receiver, a wireless medium. The method includes receiving, at an automatic gain controller during the step of sensing, estimated signal power generated using a function of an output of an active power estimator. The active power estimator is one of a first power estimator that receives an in-phase signal or a second power estimator that receives a quadrature signal. The other of the first or second power estimators is an inactive power estimator.

### BRIEF DESCRIPTION OF THE DRAWINGS

Fig. 1A is a block diagram depicting a wireless local area network (WLAN) radio according to embodiments.
Fig. 1B is a block diagram depicting WLAN radio according to other embodiments.
Fig. 2 is a block diagram depicting a WLAN receiver in a WLAN radio according to embodiments.
Fig. 3 is a block diagram depicting a receiver in a WLAN radio according to other embodiments.
Fig. 4 is a block diagram depicting a portion of a WLAN frame.
Fig. 5 is a block diagram illustrating the relationship between power estimation modes, automatic gain control, and operating modes of a WLAN radio according to embodiments.
Fig. 6 is a flow diagram depicting a method of power estimation for automatic gain control in a WLAN receiver according to embodiments.
Fig. 7 is a flow diagram depicting a method of power estimation for automatic gain control in a WLAN receiver according to further embodiments.
Fig. 8 is a flow diagram depicting a method of power estimation for automatic gain control in a WLAN receiver according to further embodiments.

### DETAILED DESCRIPTION

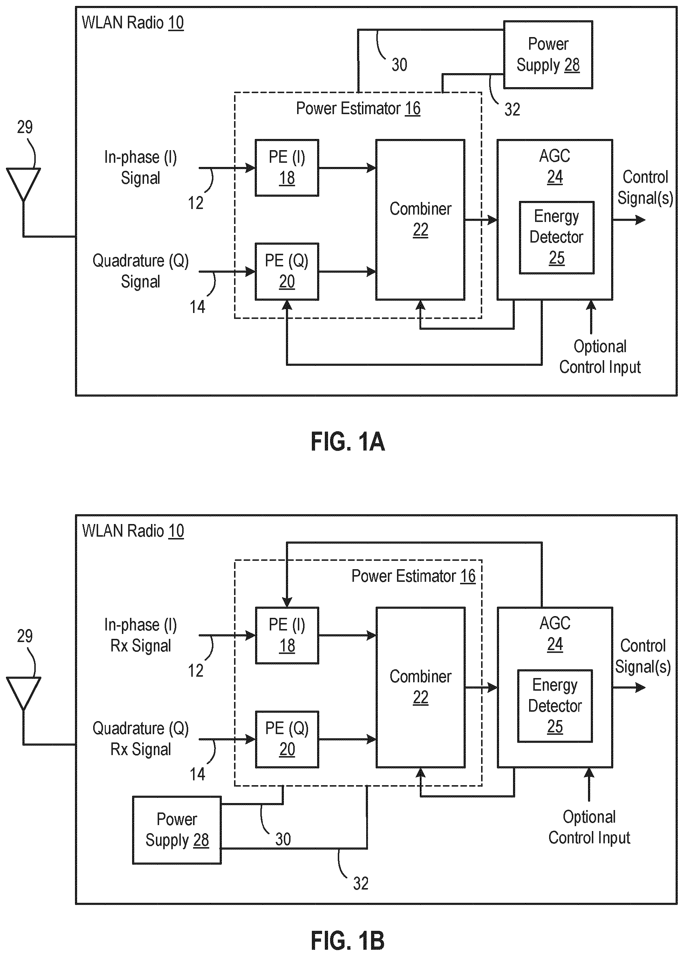

Fig. 1A is a block diagram depicting a wireless local area network (WLAN) radio 10 according to embodiments. WLAN radio 10 can be included in any type of WLAN device (e.g., wireless router, computer, mobile device, etc.). A WLAN may be a network of devices that communicate over a wireless medium. A radio may be a transceiver that includes receiver circuits for receiving radio frequency (RF) signals and transmitter circuits for transmitting RF signals. An RF signal may be an electromagnetic signal having a frequency in the RF spectrum. A WLAN radio may be a radio for transmitting and receiving RF signals in a WLAN. The techniques described herein are implemented using the receiver circuits and thus description of the transmitter circuits of WLAN radio 10 is omitted for clarity. WLAN radio 10 includes a power estimator 16 and an automatic gain controller (designated as "AGC" 24). A power estimator (PE) may be a circuit that estimates the power of a signal. An AGC may be a circuit that controls gain of amplifier(s) based on signal(s) output from the amplifier(s). Power estimator 16 includes an in-phase PE 18, a quadrature PE 20, and a combiner 22. An output of power estimator 16 is coupled to an input of AGC 24.

In operation, WLAN radio 10 receives an RF signal from a selected channel of the wireless medium using antenna 29 and receiver circuits (examples discussed below). WLAN radio 10 processes the RF signal using the receiver circuits, which include amplifier(s), to recover a baseband signal having in-phase (I) and quadrature (Q) component signals (designated the "in-phase (I)-signal 12" and the "quadrature (Q)-signal 14," respectively). A baseband signal may be a signal that has zero frequency or a bandwidth between zero frequency and a greater-than zero frequency (e.g., unmodulated signal). An in-phase signal may be a signal having a phase that aligns with a first sinusoid, and a quadrature signal may be a signal having a phase that aligns with a second sinusoid that is ninety degrees out of phase with the first sinusoid. I-signal 12 and Q-signal 14 can be analog or digital signals, depending on the receiver circuits. Power estimator 16 is operable to determine an instantaneous signal power of the baseband signal, e.g.,, the power of the baseband signal at any given moment in time. Power estimator 16 provides a signal to AGC 24 that conveys estimated signal power of the baseband signal. Estimated signal power may be measurements of the instantaneous signal power of the baseband signal made over time. AGC 24 performs any type of AGC algorithm known in the art using the estimated signal power as parametric input. AGC 24 generates control signal(s) for controlling gain of amplifier(s) in the receiver circuits.

In-phase PE 18 receives I-signal 12 as input. Quadrature PE 20 receives Q-signal 14 as input. An in-phase PE may be a PE that receives an in-phase signal. A quadrature PE may be a PE that receives a quadrature signal. An output of in-phase PE 18 is coupled to a first input of a combiner 22. An output of quadrature PE 20 is coupled to a second input of combiner 22. An output of combiner 22 is coupled to an input of AGC 24. A control input of quadrature PE 20 is coupled to a first control output of AGC 24. A control input of combiner 22 is coupled to a second control output of AGC 24. A combiner may be a circuit that has inputs and an output, where the output is a function of one or more of the inputs as determined by another one of the inputs referred to as the control input. The output of combiner 22 supplies the estimated signal power to AGC 24, where the output of combiner 22 is a function of the output of in-phase PE 18, a function of the output of quadrature PE 20, or a function of both, depending on the control input of combiner 22.

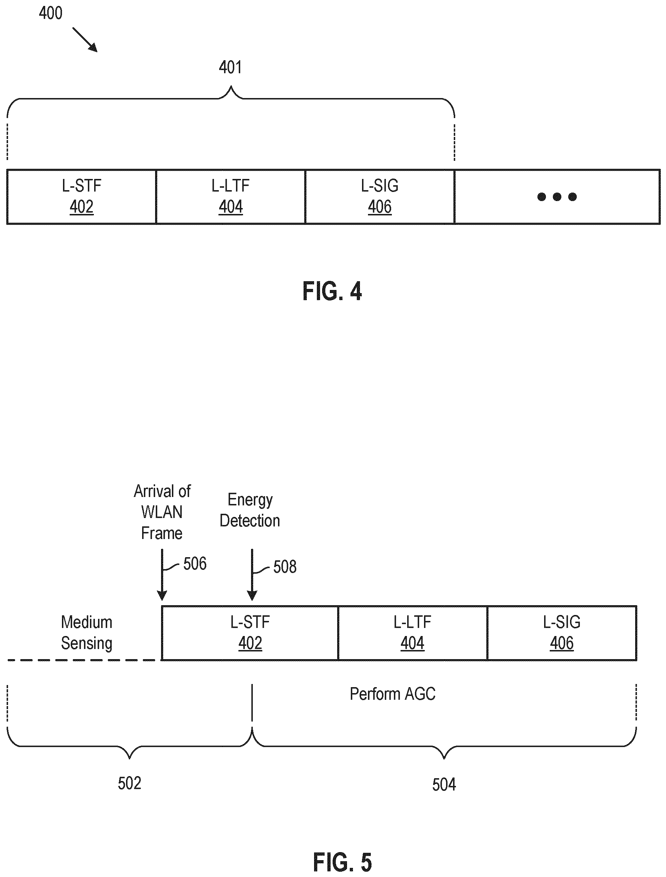

Fig. 4 is a block diagram depicting a portion of an example WLAN frame 400. A frame may be a unit of data. A frame may also be referred to as a packet. A WLAN frame or WLAN packet may be a unit of data transmitted or received in a WLAN. In the example, WLAN frame 400 includes a preamble 401. A preamble may be a portion of the frame or packet having a known structure. In the example, preamble 401 comprises a legacy short training field (L-STF) 402, a legacy long training field (L-LTF) 404, and a legacy signal field (L-SIG) 406. Preamble 401 is also known as a "legacy preamble" of a WLAN frame. WLAN frame 400 can include a non-legacy preamble portion depending on the particular 802.11 family. The WLAN frame 400 includes a data portion after preamble 401 and any non-legacy preamble portion. The non-legacy preamble portion (if present) and the data portion are omitted for clarity and represented by the ellipsis. L-STF 402 is a data sequence such that it has equal average power on both I and Q components of the carrier signal in the time domain. A source WLAN radio transmits WLAN frame(s) 400 towards a destination WLAN radio (e.g., WLAN radio 10) over a selected channel of the wireless medium on a modulated RF carrier. WLAN radio 10 receives an RF signal after propagation through the wireless medium. WLAN frame 400 is one example WLAN frame that includes a specific preamble structure. Those skilled in the art will appreciate that other types of frames can include other preambles where all or a portion thereof has equal average power on both I and Q components of the carrier signal in the time domain.

Returning to Fig. 1A, due to the nature of at least a portion of the frame preamble having equal average power in the I and Q components of the RF signal received by WLAN radio 10, WLAN radio 10 can use single-rail power estimation during the listen mode. Listen mode may be when WLAN radio 10 monitors the wireless medium to receive frames intended for the device. WLAN radio 10 includes a power supply 28. Power supply 28 can be a voltage regulator or the like type known circuit. Power supply 28 provides power to circuits of WLAN radio 10, including a set of circuits that process the I component of the received signal and a set of circuits that process the Q component of the received signal. Assume that circuits that process the I signal component receive power from power supply 28 on a rail 30, and that circuits that process the Q signal component receive power from power supply 28 on a rail 32. The term "rail" in this context means a source of power. Since power estimator 16 includes in-phase PE 18 and quadrature PE 20, power estimator 16 can draw power from both rails 30 and 32. This is referred to as IQ power estimation. In embodiments, during the listen mode, AGC 24 can turn off quadrature PE 20. Turning off quadrature PE 20 means that quadrature PE 20 is inactive and does not operate to determine instantaneous signal power of Q-signal 14. When inactive, quadrature PE 20 can draw no power from rail 32 (or a de minimis amount of power as compared to in-phase PE 18). This is referred to as single-rail power estimation. An active power estimator may be a power estimator that draws power and performs its function of estimating signal power. An inactive power estimator may be a power estimator that draws no power, or a de minimis amount of power as compared to an active power estimator, and does not perform its function of estimating signal power.

In embodiments, during IQ power estimation, in-phase PE 18 is active and determines instantaneous signal power of I-signal 12, and quadrature PE 20 is active and determines instantaneous signal power of Q-signal 14. AGC 24 selects between IQ power estimation and single-rail power estimation and controls quadrature PE 20 to be active during IQ power estimation. In embodiments, in-phase PE 18, when active, determines the square of I-signal 12 (e.g., I²). Quadrature PE 20, when active, determines the square of Q-signal 14 (e.g., Q²). In IQ power estimation, AGC 24 controls combiner 22 to determine estimated signal power using a function of both the output of in-phase PE 18 and the output of quadrature PE 20 (e.g., I² + Q²). Those skilled in the art will appreciate that other types of known circuits/functions can be used to estimate I- and Q-signal powers and combine such I- and Q-signal powers to estimate signal power of the received baseband signal.

In embodiments, during single-rail power estimation, quadrature PE 20 is inactive as discussed above. In-phase PE 18 remains active. Note that the receiver circuits in WLAN radio 10 continue to generate both I and Q components of the baseband signal. Thus, even in single-rail power estimation, I-signal 12 is only the in-phase component of the baseband signal and not the baseband signal itself. As such, output of in-phase PE 18 only measures signal power of the I component of the baseband signal. Since quadrature PE 20 is inactive, signal power of the Q component of the baseband signal is not measured by power estimator 16. As such, AGC 24 controls combiner 22, during single-rail power estimation, to supply estimated signal power using a function of the output of in-phase PE 18 (e.g., 2*I²). Those skilled in the art will appreciate that other types of known circuits/functions can be used to estimate I-signal power.

In some embodiments, AGC 24 controls power estimator 16 to function in either the IQ power estimation mode or the single-rail power estimation mode. During listen mode, for example, AGC 24 selects the single-rail power estimation mode for power estimator 16. AGC 24 includes an energy detector 25. Energy detector 25 may be a circuit that detects energy in response to estimated signal power. AGC 24 can activate energy detector 25 while in the single-rail power estimation mode to perform energy detection. Energy detection may be the detection of energy by energy detector 25. Upon detecting energy of preamble 401 in WLAN frame 400, AGC 24 can select the IQ power estimation mode for power estimator 16. Thus, during listen mode, AGC 24 can control WLAN radio 10 to use single-rail power estimation and thereby save power. Since WLAN radio 10 can spend a significant amount of time in the listen mode, significant power can be saved. In some embodiments, when AGC 24 detects energy due to WLAN radio 10 receiving a WLAN frame, AGC 24 controls power estimator 16 to use IQ power estimation. The nature of the WLAN frame preamble or portion thereof having equal average power in the I and Q components allows for use of power estimates using only the I component of the baseband signal (or Q component as shown in Fig. 1B) in order to detect the energy of preamble 401. After detecting the energy of preamble 401, transitioning to IQ power estimation ensures AGC 24 operates accurately while receiving the WLAN frame (e.g., ensures that AGC 24 adjusts the gain of WLAN radio 10 to compensate for variations in RSSI and to ensure that the frame of interest occupies an optimal number of bits when digitized for further processing). A transition between modes may be a switch between modes (e.g., a switch from the single-rail power estimation mode to the IQ estimation mode or vice versa).

In other embodiments, when AGC 24 detects energy due to WLAN radio 10 receiving a WLAN frame, AGC 24 can maintain the single-rail power estimation mode rather than switching to the IQ power estimation mode. In some embodiments, AGC 24 can include a control input (shown as optional control input) that receives a signal from another circuit in WLAN radio 10 that controls AGC 24 to switch from the single-rail power estimation mode to the IQ power estimation mode. The switch from single-rail power estimation to IQ power estimation can be made in response to factor(s) other than detection of energy in the WLAN frame. In some embodiments, the switch from single-rail power estimation to IQ power estimation can be made in response to detection of the frame by another circuit in WLAN radio 10 using a frame detector (also referred to as a packet detector). A frame detector or packet detector may be a circuit that detects a WLAN frame by detecting signal characteristics, such as characteristics of the preamble. Frame detection (packet detection) may be the detection of a frame (packet) by a frame detector (packet detector).

Fig. 1B is a block diagram depicting WLAN radio 10 according to other embodiments. Elements of Fig. 1B that are the same or similar to those of Fig. 1A are designated with identical reference numerals. As shown in Fig. 1B, WLAN radio 10 includes the same circuits as shown in Fig. 1A. However, AGC 24 controls in-phase PE 18 rather than quadrature PE 20. During IQ power estimation, operation proceeds as described above except that AGC 24 controls in-phase PE 18 to be active along with quadrature PE 20. During single-rail power estimation, AGC 24 controls in-phase PE 18 to be inactive while quadrature PE 20 remains active. AGC 24 controls combiner to double the output of quadrature PE 20 (e.g., 2*Q²). The output signal of combiner 22 conveys 2*Q² power estimates over time to AGC 24. Those skilled in the art will appreciate that other types of known circuits/functions can be used to estimate Q-signal power. When inactive, in-phase PE 18 can draw no power from rail 30 (or a de minimis amount of power as compared to quadrature PE 20).

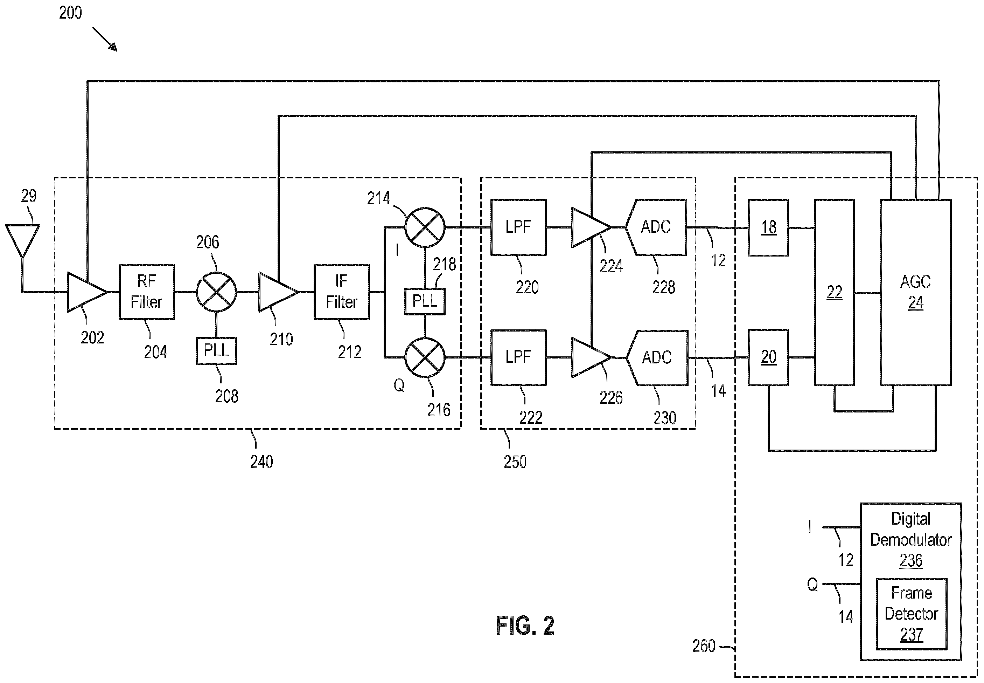

Fig. 2 is a block diagram depicting a receiver 200 in a WLAN radio 10 according to embodiments. Receiver 200 shows example receiver circuits discussed above in Figs. 1A and 1B. Receiver 200 comprises an RF front end 240, an analog baseband circuit 250, and a digital baseband circuit 260. An RF front end may be a circuit that receives and downconverts an RF signal to a baseband signal. Analog baseband circuit may be a circuit that receives and processes an analog signal version of the baseband signal. An analog signal may be a continuous-time signal. A digital baseband circuit may be a circuit that receives and processes a digital signal version of the baseband signal. A digital signal may be a sampled and quantized version of an analog signal. In the example, RF front end 240 comprises a superheterodyne RF receiver. RF front end 240 includes an amplifier 202, an RF filter 204, a mixer 206, a phase-locked loop (PLL) 208, an amplifier 210, an intermediate frequency (IF) filter 212, an in-phase mixer 214, a quadrature mixer 216, and a PLL 218. Those skilled in the art will appreciate that other RF front end structures known in the art can be used in receiver 200. In general, RF front end 240 includes one or more amplifiers under control of AGC 24 and is operable to generate I- and Q-components of a baseband signal.

An input of amplifier 202 is coupled to antenna 29. An output of amplifier 202 is coupled to an input of RF filter 204. An output of RF filter 204 is coupled to an input of mixer 206. Another input of mixer 206 is coupled to an output of PLL 208. An output of mixer 206 is coupled to an input of amplifier 210. An output of amplifier 210 is coupled to an input of IF filter 212. An output of IF filter 212 is coupled to respective inputs of in-phase mixer 214 and quadrature mixer 216. Another input of in-phase mixer 214 is coupled to a first output of PLL 218. Another input of quadrature mixer 216 is coupled to a second output of PLL 218. In operation, RF filter 204 can be a bandpass filter centered on a channel of the wireless medium. An RF signal is received by antenna 29 and downconverted to an intermediate frequency by mixer 206 after amplification and filtering by amplifier 202 and RF filter 204, respectively. PLL 208 supplies an oscillator signal having an RF frequency being tuned (e.g., 2.4 GHz, 5 GHz, 6 GHz, and like IEEE 802.11 frequency bands). The IF output from mixer 206 is amplified by amplifier 210 and filtered by IF filter 212 (e.g., a bandpass filter centered on the IF frequency) before being coupled to both the in-phase and quadrature mixers 214 and 216. In-phase mixer 214 downconverts the IF signal to baseband using an in-phase oscillator signal from PLL 218. Quadrature mixer 216 downconverts the IF signal to baseband using a quadrature oscillator signal from PLL 218. PLL 218 generates in-phase and quadrature oscillator signals having the IF frequency.

Analog baseband circuits 250 comprise low-pass filters (LPFs) 220 and 222, amplifiers 224 and 226, and analog-to-digital converters (ADCs) 228 and 230. An I-baseband signal output by in-phase mixer 214 passes through LPF 220 and amplifier 224 before being input to ADC 228. ADC 228 digitizes the I-baseband signal. A Q-baseband signal output by the quadrature mixer 216 passes through LPF 222 and amplifier 226 before being input to ADC 230. ADC 230 digitizes the Q-baseband signal. Analog baseband circuits 250 supply the I- and Q-signals 12 and 14, discussed in Figs. 1A and 1B above.

In the embodiment, AGC 24 and power estimator 16 are part of digital baseband circuits 260. Digital baseband circuits 260 can include various other digital circuits, such as digital demodulator 236. In-phase PE 18 has an input coupled to an output of ADC 228 for receiving I-signal 12. Quadrature PE 20 has an input coupled to an output of ADC 230 for receiving Q-signal 14. Digital demodulator 236 also receives I- and Q-signals 12 and 14 for performing digital demodulation of the baseband signal. Digital demodulator 236 can include a frame detector 237 that performs frame detection, as described above. Digital demodulator 236 can supply a control signal to AGC 24 with an indication of frame detection, which can cause AGC 24 to transition from single-rail power estimation mode to IQ power estimation mode. As shown in Figs. 1A and 1B, outputs of in-phase PE 18 and quadrature PE 20 are coupled to inputs of combiner 22. The output of combiner 22 is coupled to the input of AGC 24. In the example shown, AGC 24 controls quadrature PE 20. However, as shown in the embodiment of Fig. 1B, AGC 24 alternatively controls in-phase PE 18. Operation of AGC 24 and power estimator 16 is described above. In the example, AGC 24 provides amplifier control signals to amplifier 202, amplifier 210, and amplifiers 224 and 226. Those skilled in the art will appreciate that AGC 24 can control any number of amplifiers present in at least one of RF front end 240, analog baseband circuits 250, and digital baseband circuits 260.

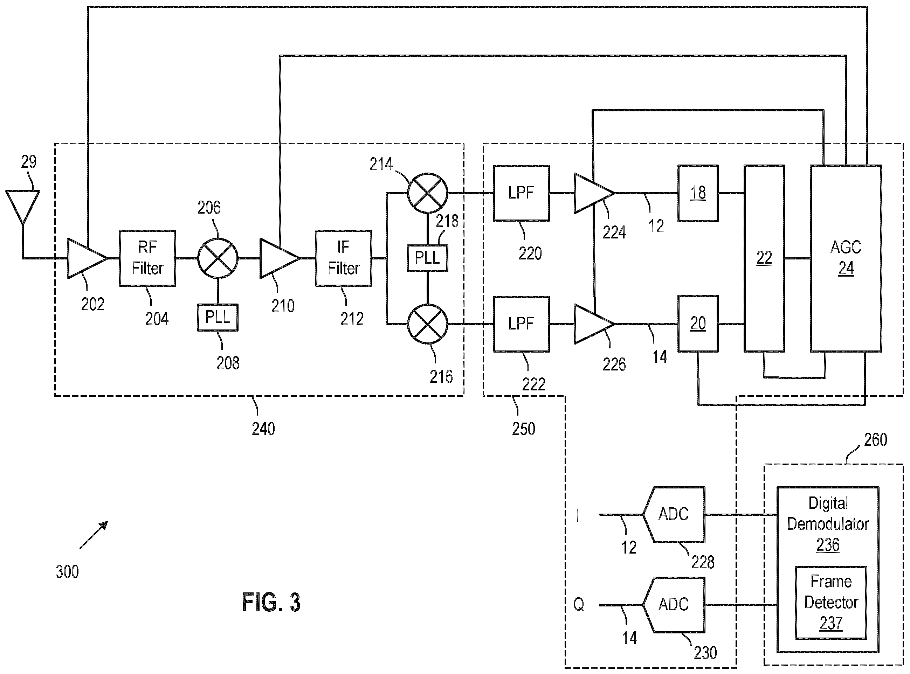

Fig. 3 is a block diagram depicting a receiver 300 in a WLAN radio 10 according to embodiments. Receiver 300 shows example receiver circuits discussed above in Figs. 1A and 1B. Elements in Fig. 3 that are the same or similar to those of Fig. 2 are designated with identical reference numerals. Receiver 300 comprises RF front end 240, analog baseband circuits 250, and digital baseband circuits 260. RF front end 240 is described above with respect to Fig. 2. In the embodiment, AGC 24 and power estimator 16 are part of analog baseband circuit 250. An input of in-phase PE 18 is coupled to an output of amplifier 224 for receiving I-signal 12. An input of quadrature PE 20 is coupled to an output of amplifier 226 for receiving Q-signal 14. I- and Q-signals 12 and 14 are coupled to ADCs 228 and 230, respectively. Outputs of ADCs 228 and 230 are coupled to inputs of digital demodulator 236. Digital baseband circuit 260 includes digital demodulator 236 and other digital circuits (now shown).

Fig. 5 is a block diagram illustrating the relationship between power estimation modes, AGC, and operating modes of WLAN radio 10 according to embodiments. In absence of a WLAN frame, WLAN radio 10 performs medium sensing during the listen mode. AGC 24 controls power estimator 16 to use single-rail power estimation thereby saving power. At time 506, a WLAN frame 400 is present in the baseband signal. At a time 508 after time 506, AGC 24 detects the energy of L-STF 402. Upon detecting the energy of L-STF 402, AGC 24 controls power estimator 16 to use IQ power estimation in order to perform accurate automatic gain control. Thus, during an interval 502 that includes medium sensing up to time 508 of energy detection, power estimator 16 uses single-rail power estimation to conserve power. During an interval 504 after time 508 and while WLAN frame 400 is present in baseband signal, power estimator 16 uses IQ power estimation for accurate automatic gain control. AGC 24 performs an AGC algorithm during interval 504. AGC 24 performs an energy detection algorithm during interval 502.

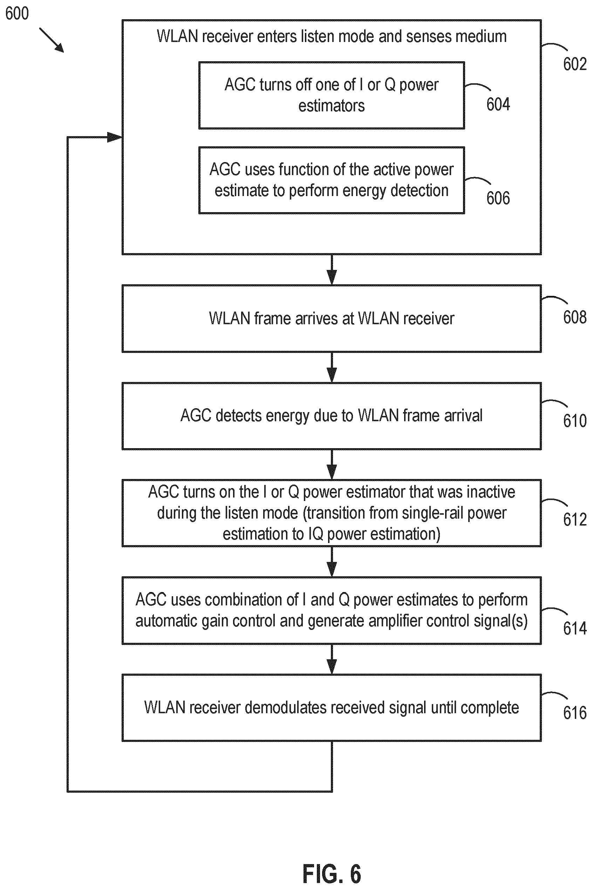

Fig. 6 is a flow diagram depicting a method 600 of power estimation for automatic gain control in a WLAN receiver according to embodiments. Method 600 begins at step 602, where a WLAN receiver (e.g., WLAN receiver 200 or 300) enters listen mode and senses the wireless medium. During step 602, at step 604, AGC 24 turns off one of in-phase and quadrature PEs 18 and 20. During step 602, at step 606, AGC 24 uses a function of the active power estimate to perform energy detection (e.g., twice the active power estimate). Thus, if in-phase PE 18 is inactive (turned-off), then the active power estimate is generated by quadrature PE 20. If instead quadrature PE 20 is inactive (turned-off), then the active power estimate is generated by in-phase PE 18. Thus, in step 602, AGC 24 controls power estimator 16 to use single-rail power estimation.

At step 608, a WLAN frame arrives at the WLAN receiver. The WLAN frame is present in the baseband signal. As discussed above, the nature of at least a portion of the WLAN preamble having equal average power in the I and Q components allows AGC 24 to detect energy of the WLAN frame preamble while using single-rail power estimation. At step 610, AGC 24 detects the energy due to the presence of the WLAN frame preamble (e.g., L-STF 402). At step 612, AGC 24 turns on the inactive power estimator (e.g., either the in-phase PE 18 or the quadrature PE 20, whichever was inactive during single-rail power estimation). That is, AGC 24 controls power estimator 16 to use IQ power estimation. At step 614, AGC 24 uses a combination of I and Q power estimates to perform automatic gain control and generate amplifier control signal(s). At step 616, the WLAN receiver demodulates the received signal and process the WLAN frame. At some point after step 616, the WLAN receiver again enters listen mode and returns to step 602.

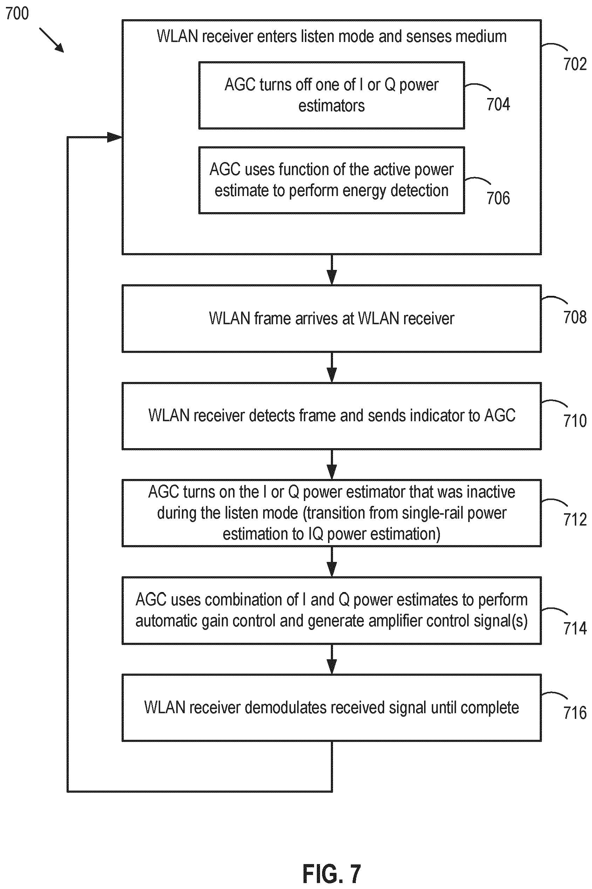

Fig. 7 is a flow diagram depicting a method 700 of power estimation for automatic gain control in a WLAN receiver according to embodiments. Method 700 is similar to method 600, except that AGC 24 does not transition from single-rail power estimation to IQ power estimation based on energy detection. Rather, AGC 24 receives an indication of frame detection (e.g., from frame detector 237). Method 700 begins at step 702, where a WLAN receiver (e.g., WLAN receiver 200 or 300) enters listen mode and senses the wireless medium. During step 702, at step 704, AGC 24 turns off one of in-phase and quadrature PEs 18 and 20. During step 702, at step 706, AGC 24 uses a function of the active power estimate to perform energy detection (e.g., twice the active power estimate). Thus, if in-phase PE 18 is inactive (turned-off), then the active power estimate is generated by quadrature PE 20. If instead quadrature PE 20 is inactive (turned-off), then the active power estimate is generated by in-phase PE 18. Thus, in step 702, AGC 24 controls power estimator 16 to use single-rail power estimation.

At step 708, a WLAN frame arrives at the WLAN receiver. The WLAN frame is present in the baseband signal. At step 710, the WLAN receiver detects the WLAN frame and sends an indicator to AGC 24 of the frame detection. At step 712, AGC 24 turns on the inactive power estimator (e.g., either the in-phase PE 18 or the quadrature PE 20, whichever was inactive during single-rail power estimation). That is, AGC 24 controls power estimator 16 to use IQ power estimation. At step 714, AGC 24 uses a combination of I and Q power estimates to perform automatic gain control and generate amplifier control signal(s). At step 716, the WLAN receiver demodulates the received signal and process the WLAN frame. At some point after step 716, the WLAN receiver again enters listen mode and returns to step 702.

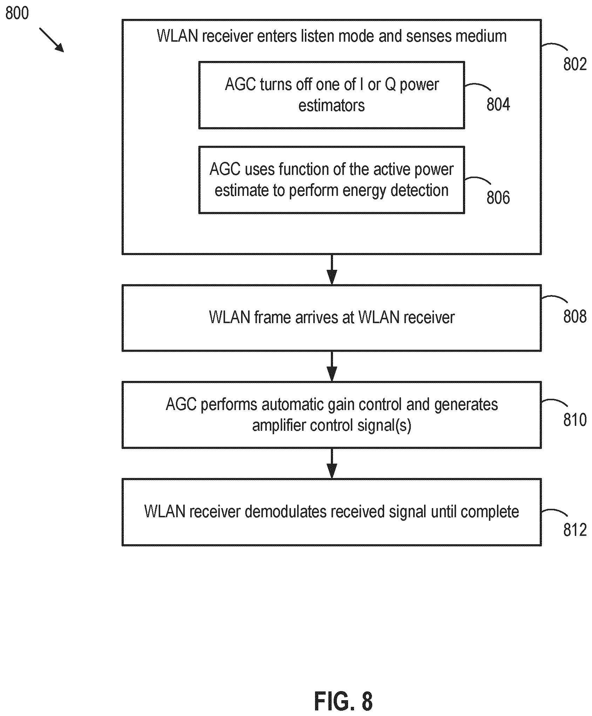

Fig. 8 is a flow diagram depicting a method 800 of power estimation for automatic gain control in a WLAN receiver according to embodiments. Method 800 is different from methods 600 and 700 in that AGC 24 does not transition from the single rail power estimation mode to the IQ power estimation mode in response to energy detection or frame detection. Rather, AGC 24 performs automatic gain control in single-rail power estimation mode. Method 800 begins at step 802, where a WLAN receiver (e.g., WLAN receiver 200 or 300) enters listen mode and senses the wireless medium. During step 802, at step 804, AGC 24 turns off one of in-phase and quadrature PEs 18 and 20. During step 802, at step 806, AGC 24 uses a function of the active power estimate to perform energy detection (e.g., twice the active power estimate). Thus, if in-phase PE 18 is inactive (turned-off), then the active power estimate is generated by quadrature PE 20. If instead quadrature PE 20 is inactive (turned-off), then the active power estimate is generated by in-phase PE 18. Thus, in step 802, AGC 24 controls power estimator 16 to use single-rail power estimation. At step 808, a WLAN frame arrives at the WLAN receiver. The WLAN frame is present in the baseband signal. At step 810, AGC 24 uses the active power estimates to perform automatic gain control and generate amplifier control signal(s). At step 812, the WLAN receiver demodulates the received signal and process the WLAN frame.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

## Claims

1. A receiver, comprising:
a first power estimator operable to receive an in-phase signal;
a second power estimator operable to receive a quadrature signal;
a combiner coupled to outputs of the first and second power estimators, the combiner having an output that supplies estimated signal power; and
an automatic gain controller coupled to the output of the combiner, the automatic gain controller operable to, in a first mode, turn off one of the first or second power estimators such that the one of the first or second power estimators is an inactive power estimator and the other is an active power estimator, and control the combiner to generate the estimated signal power using a function of an output of active power estimator.

2. The receiver of claim 1, wherein the automatic gain controller is operable to, in a second mode, turn on the inactive power estimator such that both the first and second power estimators are active, and control the combiner to generate the estimated signal power using a function of both outputs of the first and second power estimators.

3. The receiver of claim 2, wherein the automatic gain controller is operable to perform energy detection while in the first mode, and/or
wherein the first power estimator is operable to square the in-phase signal, the second power estimator is operable to square the quadrature signal, and wherein the combiner is operable to, in the first mode, double the output of the active power estimator and, in the second mode, sum the outputs of the first and second power estimators.

4. The receiver of any of claims 1 to 3, wherein the automatic gain controller selects the first mode during a listen mode.

5. The receiver of any of claims 1 to 4, wherein the automatic gain controller is operable to detect energy of a WLAN frame during the first mode and, in response to detecting the energy, transition to a second mode where the automatic gain controller turns on the inactive power estimator such that both the first and second power estimators are active, and control the combiner to generate the estimated signal power using a function of both outputs of the first and second power estimators.

6. The receiver of any of claims 1 to 5, wherein the automatic gain controller is operable to receive an indication of detection of a WLAN frame during the first mode and, in response to detection of the WLAN frame, transition to a second mode where the automatic gain controller turns on the inactive power estimator such that both the first and second power estimators are active, and control the combiner to generate the estimated signal power using a function of both outputs of the first and second power estimators.

7. A receiver, comprising:
a radio frequency (RF) front end;
an analog baseband circuit coupled to the RF front end;
a digital baseband circuit coupled to the analog baseband circuit;
a power estimator comprising a first power estimator operable to receive an in-phase signal, a second power estimator operable to receive a quadrature signal, and a combiner coupled to outputs of the first and second power estimators, the combiner having an output that supplies estimated signal power; and
an automatic gain controller coupled to the output of the combiner, the automatic gain controller operable to, in a first mode, turn off one of the first or second power estimators such that the one of the first or second power estimators is an inactive power estimator and the other is an active power estimator, and control the combiner to generate the estimated signal power using a function of an output of active power estimator;
where the RF front end and the analog baseband circuit are operable to generate the in-phase signal and the quadrature signal.

8. The receiver of claim 7, wherein the power estimator and the automatic gain controller are part of the analog baseband circuit, and wherein the in-phase signal and the quadrature signal comprise analog signals, or
wherein the power estimator and the automatic gain controller are part of the digital baseband circuit, and wherein the in-phase signal and the quadrature signal comprise digital signals.

9. The receiver of claim 7 or 8, wherein the automatic gain controller is operable to in response to energy detection or frame detection, transition to a second mode where the automatic gain controller turns on the inactive power estimator such that both the first and second power estimators are active, and control the combiner to generate the estimated signal power using a function of both outputs of the first and second power estimators.

10. The receiver of claim 9, wherein the automatic gain controller is operable to perform an automatic gain control algorithm, in the second mode, to control at least one amplifier in at least one of the RF front end, the analog baseband circuit, and the digital baseband circuit, and/or
wherein the automatic gain controller is operable to detect the energy of a portion of a preamble in a WLAN frame, the portion having equal average power in both the in-phase and quadrature signals.

11. The receiver of any of claims 7 to 10, wherein the automatic gain controller is operable to select the first mode during a listen mode.

12. A method of automatic gain control in a receiver, comprising:
sensing, by the receiver, a wireless medium; and
receiving, at an automatic gain controller during the step of sensing, estimated signal power generated using a function of an output of an active power estimator, the active power estimator being one of a first power estimator that receives an in-phase signal or a second power estimator that receives a quadrature signal, the other of the first or second power estimators being an inactive power estimator.

13. The method of claim 12, further comprising:
detecting, at the automatic gain controller, energy of a frame using the estimated signal power;
turning on, by the automatic gain controller, the inactive power estimator; and
performing, by the automatic gain controller, an automatic gain control algorithm based on outputs of both the first and second power estimators, or
the method further comprising:
receiving, at the automatic gain controller, an indication of detection of a frame;
turning on, by the automatic gain controller, the inactive power estimator; and
performing, by the automatic gain controller, an automatic gain control algorithm based on outputs of both the first and second power estimators.

14. The method of claim 12 or 13, further comprising:
performing, by the automatic gain controller, an automatic gain control algorithm based on output of the active power estimator.

15. The method of any of claims 12 to 14, wherein the first power estimator is operable to square the in-phase signal, the second power estimator is operable to square the quadrature signal, and wherein the function, in a first mode, doubles the output of the active power estimator and, in the a second mode, sums the outputs of the first and second power estimators, and
in particular, wherein the automatic gain control selects the first mode during a listen mode.
